# EUROPÄISCHE PATENTSCHRIFT

(11) **EP 0 927 508 B1**
(45) Veröffentlichungstag und Bekanntmachung des Hinweises auf die Patenterteilung: **14.06.2000**
(21) Anmeldenummer: 97935473.5
(22) Anmeldetag: 23.07.1997
(51) Int. Cl.: H05K 5/00, B60R 21/32, B60R 22/46

(54) **AIRBAG-STEUERGERÄT**
AIR BAG CONTROL UNIT
DISPOSITIF DE COMMANDE POUR AIRBAG

(30) Priorität: 19.09.1996 DE 19638454
(43) Veröffentlichungstag der Anmeldung: 07.07.1999
(73) Patentinhaber: SIEMENS AKTIENGESELLSCHAFT, 80333 München (DE)
(72) Erfinder: PLANKL, Christian, D-93055 Burgweinting (DE); RIEDERER, Ludwig, D-93107 Thalmasing (DE)
(86) Internationale Anmeldenummer: DE9701561
(87) Internationale Veröffentlichungsnummer: WO9812904

(56) Entgegenhaltungen:
- DE-A- 4 111 883
- DE-C- 19 622 228
- DE-U- 8 215 422
- FR-A- 2 728 847

## Beschreibung

Die Erfindung betrifft ein Airbag-Steuergerät gemäß Oberbegriff des Anspruchs 1; (vgl. DE-A-4 111 883).

Elektronische Steuergeräte für Personenschutzeinrichtungen in Kraftfahrzeugen wie Airbags, Gurtstrammersysteme etc. umfassen auf einer Leiterplatte diverse elektronische Bauteile, die von einem deckelversehenen Gehäuse umschlossen sind, wie beispielsweise in der DE 44 06 499 C2 beschrieben ist. Zur Befestigung des Gehäuses am Kraftfahrzeug weist der Gehäusedeckel Befestigungslaschen oder Flansche auf, über die außerdem die Orientierung des Steuergeräts festgelegt wird. Diese feste Orientierung des Steuergeräts ist zwingend, da der üblicherweise verwendete Beschleunigungssensor eine vorgegebene Empfindlichkeitsrichtung hat. Die Leiterplatte wird im Gehäuse mittels Schrauben befestigt. Um sich aus langen Leitungswegen ergebende Strahlung zu reduzieren, ist meist zentral am Gehäuse eine Schraube als Ableitelement angebracht.

Der Erfindung liegt die Aufgabe zugrunde, eine Befestigung für ein Airbag-Steuergerät zu schaffen, die eine einfache, kosten günstige Montage des Steuergeräts gestattet, wobei auftretende Schwingungsprobleme im Bereich der Leiterplatte auf ein Minimum herabgesetzt sind.

Diese Aufgabe ist erfindungsgemäß bei einem Airbag-Steuergerät mit den Merkmalen des Anspruchs 1 gelöst.

Vorteilhafte weitere Ausgestaltungen der Erfindung sind Gegenstand der Unteransprüche.

Das erfindungsgemäße Airbag-Steuergerät kann unter Verwendung von kostengünstig herstellbaren Teilen, etwa einem Druckgußgehäuse und einem durch Tiefziehen hergestellten Deckel, schnell und mit wenigen Befestigungsteilen an der Fahrzeugkarosserie befestigt werden. Die Montage ist damit auch kostengünstig. Dies wird dadurch ermöglicht, daß erfindungsgemäß nur eine zentrale Befestigungsstelle für das komplette Steuergerät vorhanden ist, somit nur ein Befestigungsvorgang anstelle von bisher beispielsweise vier Schraubverbindungen erforderlich ist. Damit werden mindestens zwei Bolzen und Muttern, somit nicht nur Montagezeit, sondern auch Material eingespart.

Durch das Entfallen von bisher üblichen Befestigungslaschen steht mehr Raum für das Steuergerät selbst zur Verfügung, dessen Innenvolumen so vergrößert werden kann. Die Leiterplattenfläche kann vergrößert werden, so daß keine zweiseitige Leiterplattenbestückung oder Mehrlagenanordnung erforderlich ist.

Darüber hinaus ergibt sich durch die zentrale Befestigungsstelle die Möglichkeit einer zentralen Einspannung der Leiterplatte. Hierdurch können Schwingungen der Leiterplatte deutlich reduziert oder sogar vermieden werden, die sich auf den schwingungempfindlichen elektronischen Beschleunigungssensor nachteilig auswirken, und es kann ggf. auf das Vergießen des Beschleunigungssensors verzichtet werden, wie es in der oben erwähnten DE 44 06 499 C2 beschrieben ist.

Wird eine formschlüssige Verbindung von Steuergerät und dem betreffenden Befestigungsteil mit asymmetrischer Form vorgesehen, ergibt sich automatisch eine verdrehsichere und lagegenaue Montage des Steuergeräts im Kraftfahrzeug.

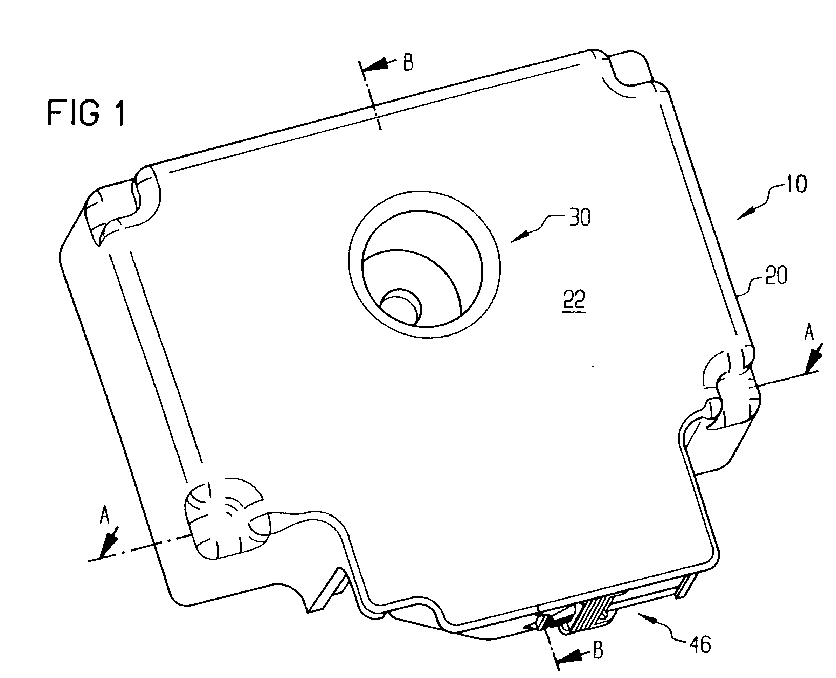

Ein Ausführungsbeispiel der Erfindung wird im folgenden anhand der Zeichnung erläutert. Es zeigen
- Figur 1:: Eine perspektivische Draufsicht auf die Gehäusebodenseite eines Airbag-Steuergeräts,
- Figur 2:: Eine perspektivische Ansicht auf die Deckelseite des Gehäuses,
- Figur 3:: Eine Schnittansicht längs Linie B-B in Fig. 1,
- Figur 4:: Eine Schnittansicht längs Linie A-A in Fig. 1 und
- Figur 5:: Eine perspektivische Ansicht eines Gewindeschweißbolzens für die Montage des Gehäuses.

Ein Airbag-Steuergerät 10 umfaßt ein Gehäuse 20, z.B. ein Aluminium-Druckgußgehäuse mit einem Boden 22, Seitenwänden 24 und einen beispielsweise aus Tiefziehblech hergestellten Dekkel 26. Das Gehäuse enthält eine Leiterplatte 40, auf der eine Auswerteschaltung mit diversen Bauteilen 42 und ein mit der Auswerteschaltung verbundener Beschleunigungssensor 44 angeordnet sind.
Ein Steckverbinder 46 dient als Schnittstelle und Anschluß zum Airbag und anderen Steuergeräten im Kraftfahrzeug. Das Gehäuse 20 weist eine zentrale Durchführung 30 auf, wobei der Gehäuseboden 22 nach innen in das Gehäuse 20 eingezogen ist und sich mit Anformteilen durch das Gehäuse hindurch bis zur anderen Außenseite erstreckt.

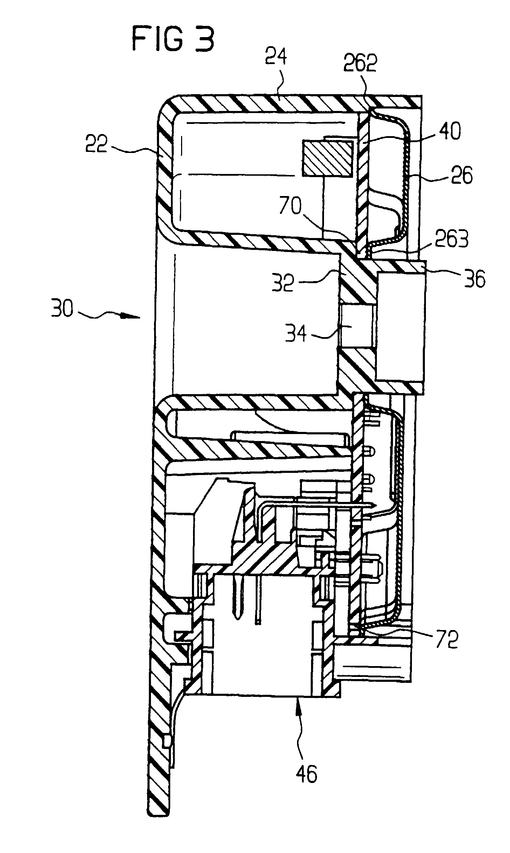

Mehr im einzelnen: Der Gehäuseboden 22 ist in der Gehäusemitte nach innen gebogen, so daß er ein Sackloch mit einem Sacklochboden 32 mit einer mittigen Öffnung 34 bildet. Der Sacklochboden 32 befindet sich etwa in der Höhe der Leiterplatte 40 und weist auf der Gehäuseinnenseite eine Abstufung zum Ende des Gehäusebodens 22 auf. Durch die Abstufung ist eine Auflageschulter 70 gebildet, auf deren Funktion noch eingegangen wird. Der Sacklochboden 32 ist auf der Deckelseite zu einem Zylinderring 36 hochgezogen, der über den Deckel 26 und die Höhe der Seitenwand 24 vorsteht, wie aus Figur 3 zu ersehen ist. Der Zylinderring 36 ist unter Bildung eines massiven Segmentabschnitts 38 mit asymmetrischem Innenraum ausgebildet, worauf ebenfalls später noch eingegangen wird. Der Außendurchmesser des Zylinderrings 36 ist kleiner als der Durchmesser des Außenumfangs der die Durchführung 30 bildenden Sacklochwand. Wie die obige Beschreibung zeigt, ist die zentrale Durchführung des Gehäuses 20 hermetisch gegen das Gehäuseinnere abgeschirmt.

Der Deckel 26 weist eine zentrale Öffnung 261 auf und ist im-Bereich der Öffnung 261 und eines Teils der Außenkanten nachunten, d.h. zum Gehäuseinneren hin, unter Bildung von Auflagerändern 262, 263 gezogen. Im Bereich der Ecken sind die Auflageränder zu Befestigungslaschen 264 verbreitert. Der Deckel 26 ist so geformt, daß sein innerer Auflagerand 263 tiefer als der äußere Auflagerand 262 und die Befestigungslaschen 264 liegt.

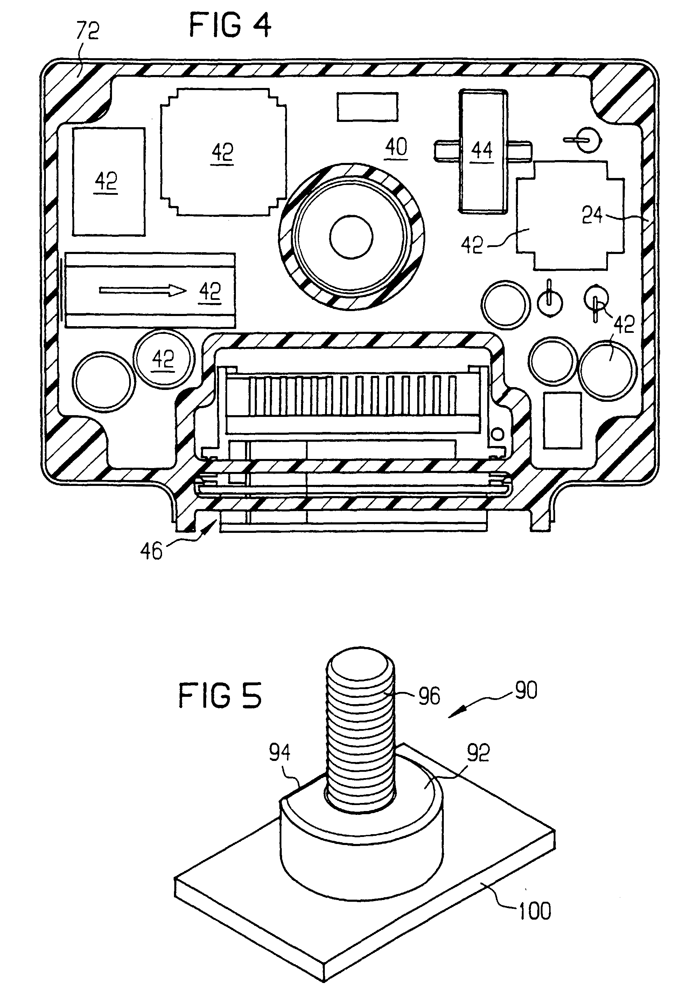

Die Seitenwand 24 des Gehäuses 20 ist in den Eckbereichen in Höhe der Leiterplatte 40 nach innen unter Bildung von Auflageschultern 72 gezogen, die in Figur 4 dargestellt sind. Auf diese Auflageschultern 72 gelangt der Deckel 26 im Bereich der Befestigungslaschen 264 zur Auflage.

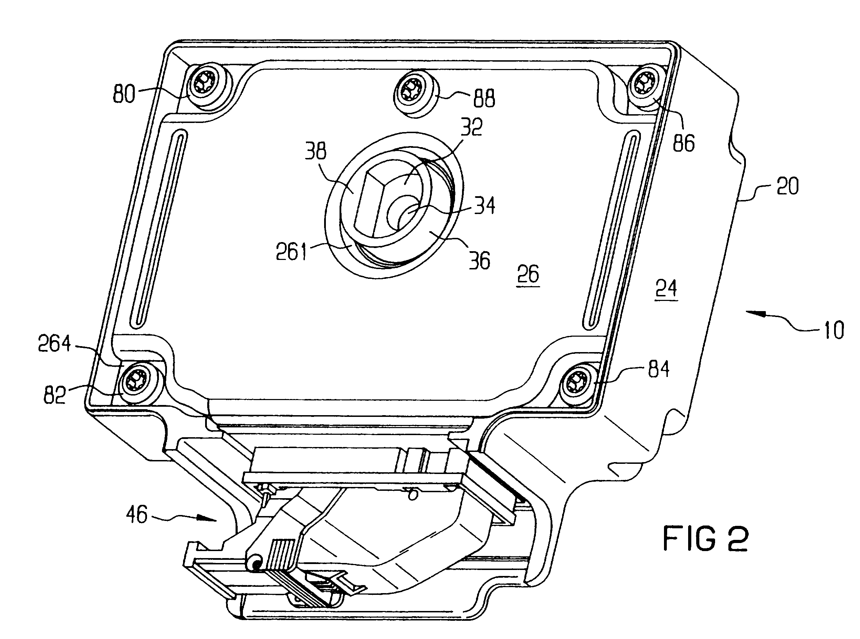

Die perspektivische Ansicht von Figur 2 veranschaulicht den Zusammenbau von Deckel 26, Leiterplatte 40 und Gehäuse 20. Hierzu dienen Schraubverbindungen, d.h. diese drei Teile werden gemeinsam mittels vier Schrauben 80, 82, 84, 86 montiert. Alternativ können auch nur drei Schrauben verwendet werden. Hierzu dient dann die zur Veranschaulichung zusätzlich eingezeichnete Schraube 88 anstelle der Schrauben 80 und 86. Bei dem Verschraubvorgang wird durch die beschriebene Deckelform und die mittig vorgesehene Auflageschulter 70 die Leiterplatte 40 in der Mitte eingespannt. Dadurch entfallen zum einen Schrauben oder sonstige Befestigungsmittel für die Leiterplatte und zum anderen werden Schwingungen der Leiterplatte verhindert. Durch die Montage des Beschleunigungssensors 44 näher an einer Einspannstelle der Leiterplatte 40, also in Randnähe, kann noch zusätzlich ein weiterer Vibrationsschutz des Beschleunigungssensors geschaffen werden. Das Befestigen und/oder Einspannen der Leiterplatte im Bereich der zentralen Durchführung am Gehäuse oder am Deckel verschafft einen zusätzlichen Auflagerpunkt für die Leiterplatte, in Leiterplattenmitte, der bei herkömmlichen Steuergeräten durch eine zusätzliche Schraube o.ä. erkauft werden mußte. Die zentrale Einspannstelle fixiert die Leiterplatte in einem zentralen Bereich, der andernfalls starke Schwingungsneigung zeigen würde. Die für das Schwingen maßgebenden Strecken zwischen Befestigungspunkten sind durch die zentrale Einspannstelle allseits gering gehalten. Die zentrale Einspannstelle ermöglicht auch eine Masseanbindung von der Leiterplatte zum Gehäuse 20 und zum Deckel 26.

Figur 5 veranschaulicht einen Gewindeschweißbolzen 90, der mit dem schematisch angedeuteten Karosserieblech 100 verschweißt ist und einen asymmetrischen Kopf 92 mit Segmentaussparung 94 sowie einen Schaft 96 aufweist.

Bei der Montage des Steuergeräts 10, d.h. des deckelversehenen Gehäuses 20, an der Fahrzeugkarosserie wird das Gehäuse mit der Deckelseite auf den Schaft 96 des Schweißbolzens 90 aufgesetzt und befindet sich dann aufgrund des Formschlusses zwischen dem Kopf 92 und dem Zylinderring 36 dann zwangsläufig in der richtigen Orientierung. Auf der Gegenseite, d.h. im Sackloch der Durchführung 30 muß dann lediglich noch eine Befestigungsmutter auf den Schaft 96 aufgeschraubt werden. Der Schweißbolzen 90 hat die Aufgabe, das Steuergerät 10 am Kraftfahrzeug zu befestigen. Darüber hinaus dient er als Ableitelement für Störstrahlung.

## Patentansprüche

1. Airbag-Steuergerät, mit einer elektronische Bauteile (42) tragenden Leiterplatte (40), mit einem Gehäuse (20) für die Leiterplatte (40) und mit einem Deckel (26) für das Gehäuse (20), und mit Mitteln zur Befestigung des Steuergeräts an einem Kraftfahrzeug, wobei das Gehäuse (20) als Befestigungsmittel eine im wesentlichen zentrale Durchführung (30) aufweist, gegen die das Gehäuseinnere abgeschlossen ist, **dadurch gekennzeichnet,** daß sich die zentrale Durchführung (30) des Gehäuses (20) durch die Leiterplatte (40) und den Deckel (26) erstreckt.

2. Airbag-Steuergerät nach Anspruch 1, dadurch gekennzeichnet, daß die zentrale Durchführung (30) des Gehäuses (20) zumindest bereichsweise eine asymmetrische Form aufweist, die bei Formschlußverbindung mit einem komplementär geformten Befestigungsteil (90) eine Lagefixierung bildet.

3. Airbag-Steuergerät nach Anspruch 1, dadurch gekennzeichnet, daß die Leiterplatte (40) im Bereich der zentralen Durchführung (30) am Gehäuse (20) oder am Deckel (26) gehalten oder befestigt ist.

4. Airbag-Steuergerät nach Anspruch 1, dadurch gekennzeichnet, daß im Bereich der zentralen Durchführung (30) des Gehäuses (20) eine Auflage (70) für die Leiterplatte (40) vorgesehen ist und der Deckel (26) so geformt ist, daß er die Leiterplatte (40) druckbeaufschlagt, womit eine zentrale Einspannung der Leiterplatte vorgesehen ist.

5. Airbag-Steuergerät nach Anspruch 4, dadurch gekennzeichnet, daß der Deckel (26) im Bereich der zentralen Gehäusedurchführung (30) tiefer als die Außenränder ist.

6. Airbag-Steuergerät nach Anspruch 5, dadurch gekennzeichnet, daß an der zentralen Einspannstelle (70) der Leiterplatte eine Masseanbindung an das Gehäuse (20) und den Deckel (26) vorgesehen ist.

7. Airbag-Steuergerät nach Anspruch 3, dadurch gekennzeichnet, daß die Leiterplatte (40) an mindestens einer weiteren Stelle (80,82,84,86) am Gehäuse (20) oder am Deckel (26) gehalten wird.

8. Airbag-Steuergerät nach Anspruch 7, dadurch gekennzeichnet, daß das Gehäuse (20), die Leiterplatte (40) und der Dekkel (26) gemeinsam miteinander verschraubt sind.

9. Airbag-Steuergerät nach Anspruch 1, dadurch gekennzeichnet, daß die Leiterplatte einen Beschleunigungssensor trägt.

10. Airbag-Steuergerät nach den Ansprüchen 3, 7 und 9, dadurch gekennzeichnet, daß der Beschleunigungssensor zwischen der zentralen Durchführung (30) und der weiteren Stelle (80,82,84,86) auf der Leiterplatte (40) angeordnet ist.

## Claims

1. Airbag control unit, with circuit board (40) carrying an electronic component (42), with a housing (20) for the circuit board (40) and with a cover (26) for the housing (20) and with means of mounting the control unit on a vehicle, whereby the housing (20) as a mounting has an essentially central passage (30), against which the inside of the housing is sealed, **characterised in that** the central passage (30) of the housing (20) extends through the circuit board (40) and the cover (26).

2. Airbag control unit in accordance with claim 1, characterised in that the central passage (30) of the housing (20) has, at least in one area, an asymmetric shape which when positively connected to a mounting part (90) with a mating shape, forms a locating fixing.

3. Airbag control unit in accordance with claim 1, characterised in that the circuit board (40) is held, fastened, on the housing (20) or on the cover (26) in the area of the central passage (30).

4. Airbag control unit in accordance with claim 1, characterised in that in the area of the central passage (30) of the housing (20) a support (70) is provided for the circuit board (40) and the cover (26) is so shaped that it presses against the circuit board (40), thus providing a central clamping of the circuit board.

5. Airbag control unit in accordance with claim 4, characterised in that the cover (26) is deeper than the outer rim in the area of the central housing passage (30).

6. Airbag control unit in accordance with claim 5, characterised in that the central clamping point (70) of the circuit board has a ground connection to the housing (20) and cover (26).

7. Airbag control unit in accordance with claim 3, characterised in that the circuit board (40) is held at at least one further point (80, 82, 84, 86) on the housing (20) or on the cover (26).

8. Airbag control unit in accordance with claim 7, characterised in that the housing (20), the circuit board (40) and the cover (26) are bolted together.

9. Airbag control unit in accordance with claim 1, characterised in that the circuit board carries an acceleration sensor.

10. Airbag control unit in accordance with claims 3, 7 and 9, characterised in that the acceleration sensor is arranged between the central opening (30) and the further points (80, 82, 84, 86) on the circuit board (40).

## Revendications

1. Appareil de commande de coussin gonflable, comportant une carte de circuit imprimé (40) portant des composants électroniques (42), comportant un boîtier (20) pour la carte de circuit imprimé (40) et comportant un couvercle (26) pour le boîtier (20), et comportant des moyens de fixation de l'appareil de commande sur un véhicule automobile, le boîtier (20) présentant, comme moyen de fixation, un passage essentiellement central (30) qui s'arrête contre l'intérieur du boîtier,
caractérisé en ce que le passage central (30) du boîtier (20) s'étend au travers de la carte de circuit imprimé (40) et du couvercle (26).

2. Appareil de commande de coussin gonflable suivant la revendication 1, caractérisé en ce que le passage central (30) du boîtier (20) présente au moins une zone de forme dissymétrique qui, dans le cadre d'une liaison par conjugaison de formes, constitue une fixation en position, avec une pièce de fixation (90) de forme complémentaire.

3. Appareil de commande de coussin gonflable suivant la revendication 1, caractérisé en ce que la carte de circuit imprimé (40) est maintenue ou fixée sur le boîtier (20) ou sur le couvercle (26) dans la zone du passage central (30) .

4. Appareil de commande de coussin gonflable suivant la revendication 1, caractérisé en ce que, dans la zone du passage central (30) du boîtier (20), il est prévu un appui (70) pour la carte de circuit imprimé (40), et en ce que le couvercle (26) a une forme telle qu'il applique une pression sur la carte de circuit imprimé (40), en pourvoyant ainsi à une mise en serrage centrale de la carte de circuit imprimé (40).

5. Appareil de commande de coussin gonflable suivant la revendication 4, caractérisé en ce que le couvercle (26) est, dans la zone du passage central (30), plus profond que les bords extérieurs.

6. Appareil de commande de coussin gonflable suivant la revendication 5, caractérisé en ce qu'au point de serrage central (70) de la carte de circuit imprimé (40), il est prévu une mise à la masse sur le boîtier (20) et sur le couvercle (26).

7. Appareil de commande de coussin gonflable suivant la revendication 3, caractérisé en ce que la carte de circuit imprimé (40) est maintenue en au moins un autre point (80, 82, 84, 86) sur le boîtier (20) ou sur le couvercle (26) .

8. Appareil de commande de coussin gonflable suivant la revendication 7, caractérisé en ce que le boîtier (20), la carte de circuit imprimé (40), et le couvercle (26) sont vissés ensemble les uns aux autres.

9. Appareil de commande de coussin gonflable suivant la revendication 1, caractérisé en ce que la carte de circuit imprimé porte un détecteur d'accélération.

10. Appareil de commande de coussin gonflable suivant les revendications 3, 7 et 9, caractérisé en ce que le détecteur d'accélération est disposé sur la carte de circuit imprimé (40), entre le passage central (30) et l'autre point (80, 82, 84, 86).
